# EUROPÄISCHE PATENTANMELDUNG

(11) **EP 1 584 933 A1**
(43) Veröffentlichungstag der Anmeldung: **12.10.2005**
(21) Anmeldenummer: 05006862.6
(22) Anmeldetag: 30.03.2005
(51) Int. Cl.: G01R 31/28, G01R 31/3167

(54) **Verfahren und Vorrichtung zum Testen integrierter Schaltungen**

(30) Priorität: 02.04.2004 DE 102004017787
(71) Anmelder: ATMEL Germany GmbH, 74072 Heilbronn (DE)
(72) Erfinder: Diewald, Reiner, 74081 Heilbronn (DE)

(57) **Zusammenfassung**

Vorgestellt wird ein Verfahren zum Testen integrierter Schaltungen (12), die ein Analog-Ausgangssignal (AS; 44, 46, 48; 58, 60, 62) liefern, mit den Schritten: Erzeugen einer Änderung eines Eingangssignals (40) der integrierten Schaltung (12), Erfassen einer Änderung des Ausgangssignals (AS; 44, 46, 48; 58, 60, 62) der integrierten Schaltung (12), die durch die Änderung des Eingangssignals (40) ausgelöst wurde, wenn eine vorbestimmte Bedingung (VB) erfüllt ist und Vergleichen des erfassten Ausgangssignals (M; AS; 44, 46, 48; 58, 60, 62) mit wenigstens einem vorbestimmten Vergleichskriterium. Das Verfahren zeichnet sich dadurch aus, dass die vorbestimmte Bedingung (VB) individuell für jede integrierte Schaltung (12) aus einem Zeitverhalten (ZV) des Ausgangssignals (AS; 44, 46, 48; 58, 60, 62) abgeleitet wird.

## Beschreibung

Die Erfindung betrifft ein Verfahren zum Testen integrierter Schaltungen, die ein Analog-Ausgangssignal liefern, mit den Schritten: Erzeugen einer Änderung eines Eingangssignals einer integrierten Schaltung, Erfassen einer Änderung eines Ausgangssignals der integrierten Schaltung, die durch die Änderung des Eingangssignals ausgelöst wurde, wenn eine vorbestimmte Bedingung erfüllt ist, und Vergleichen des erfassten Ausgangssignals mit wenigstens einem vorbestimmten Vergleichskriterium.

Darüber hinaus betrifft die Erfindung eine Testvorrichtung für integrierte Schaltungen mit Handhabungsmitteln zum Kontaktieren von integrierten Schaltungen, einem Eingangssignalgenerator und einer Ausgangssignal-Erfassungs- und Auswerteeinheit, wobei die Testvorrichtung eine Änderung eines Eingangssignals einer integrierten Schaltung erzeugt und eine Änderung eines Ausgangssignals der integrierten Schaltung erfasst, die durch die Änderung des Einganssignals ausgelöst wurde, wenn eine vorbestimmte Bedingung erfüllt ist, und das erfasste Ausgangssignal mit wenigstens einem vorbestimmten Vergleichskriterium vergleicht.

Ein solches Verfahren und eine solche Testvorrichtung sind per se bekannt. Integrierte Schaltungen werden in Millionenstückzahlen hergestellt. Für einige Anwendungen, so zum Beispiel bei integrierten Schaltungen für sicherheitsrelevante Funktionen wie der Steuerung einer Airbag-Auslösung, wird eine Nullfehler-Quote verlangt. Daher muss jede einzelne integrierte Schaltung, die für eine solche Anwendung vorgesehen ist, nach der Herstellung auf ihre ordnungsgemäße Funktion geprüft werden. Auch bei weniger sicherheitskritischen Anwendungen muss die Produktion zumindest stichprobenartig geprüft werden, was bei den genannten Stückzahlen immer noch sehr hohe Zahlen zu prüfender integrierter Schaltungen ergibt.

Bei dem oben genannten bekannten Verfahren wird als vorbestimmte Bedingung die Forderung verwendet, dass nach einer Änderung des Eingangssignals eine feste Wartezeit ablaufen muss, bevor ein Messwert einer Ausgangssignal-Reaktion erfasst wird. Diese Wartezeit trägt einer Baureihen-spezifischen Verzögerung Rechnung, mit der integrierte Schaltungen auf eine stimulierende Eingangssignaländerung reagieren. Die realen Verzögerungen, die bei individuellen Schaltungen auftreten, können aufgrund von Streuungen der Bauteilparameter bei verschiedenen Vertretern einer Serie von integrierten Schaltungen aus der gleichen Baureihe Streuungen aufweisen, so dass einige integrierte Schaltungen früher und andere integrierte Schaltungen später auf eine Eingangssignaländerung reagieren.

Um eine sichere Unterscheidung von noch guten und bereits schlechten integrierten Schaltungen zu ermöglichen, muss die feste Wartezeit so vorbestimmt sein, dass auch im Rahmen der erlaubten Schwankungen zwar langsamer, aber immer noch ausreichend schnell reagierende integrierte Schaltungen noch als gut erkannt werden. Daraus ergibt sich, dass Messwerte für im Rahmen der erlaubten Schwankungen schnell reagierende Bauteile unnötig spät aufgenommen werden, was zwar für die Qualität der Messung unkritisch ist, aber die für eine Prüfung einer großen Zahl von gleichartigen integrierten Schaltungen erforderliche Messzeit verlängert. Diese Verlängerung der Testzeit verringert den Durchsatz einer einzelnen Testvorrichtung, so dass für eine vorgegebene Rate, mit der integrierte Schaltungen zu prüfen sind, mehr Testvorrichtungen bereitgestellt werden müssen. Die verlängerte Messzeit muss durch höhere Investitionen für mehr Testvorrichtungen, zugehörige Handhabungssysteme, Einbaufläche, Stromversorgung usw. aufgefangen werden.

Vor diesem Hintergrund besteht die Aufgabe der Erfindung in der Angabe eines Verfahrens und einer Testvorrichtung, mit der die oben genannten Nachteile zumindest verringert werden.

Diese Aufgabe wird bei einem Verfahren der eingangs genannten Art dadurch gelöst, dass die vorbestimmte Bedingung individuell für jede integrierte Schaltung aus einem Zeitverhalten des Ausgangssignals abgeleitet wird.

Ferner wird diese Aufgabe bei einer Testvorrichtung der eingangs genannten Art dadurch gelöst, dass die Testvorrichtung die vorbestimmte Bedingung individuell für jede integrierte Schaltung aus einem Zeitverhalten des Ausgangssignals ableitet.

Durch diese Merkmale wird die Aufgabe der Erfindung vollkommen gelöst. Durch das Ableiten IC-individueller vorbestimmter Bedingungen aus dem individuellen Zeitverhalten des Ausgangssignals einer integrierten Schaltung können schneller reagierende integrierte Schaltungen im Rahmen eines Tests früher geprüft werden als nach dem bekannten Verfahren. Dadurch ergibt sich bei einer Mittelung über viele Testzyklen insgesamt eine kürzere Testzeit, so dass die von einer Testvorrichtung bewältigte Menge an getesteten integrierten Schaltungen ansteigt. Als Folge kann bei einer vorgegebenen Menge zu testender integrierter Schaltungen die Zahl der Testvorrichtungen einschließlich der zugehörigen Handhabungsmittel verringert werden, was den Platzbedarf der gesamten Testanlage und die mittleren Testkosten für jede einzelne integrierte Schaltung senkt.

Mit Blick auf Ausgestaltungen des Verfahrens ist bevorzugt, dass das Ausgangssignal nach einer Änderung des Eingangssignals fortlaufend überwacht wird und dass die vorbestimmte Bedingung dann als erfüllt gilt, wenn das Ausgangssignal in einem vorbestimmten Wertebereich hineinläuft.

Diese Ausgestaltung ist für integrierte Schaltungen geeignet, bei denen eine vergleichsweise starke Reaktion des Ausgangssignals auftritt. Das Hineinlaufen des Ausgangssignals in einen vorbestimmten Wertebereich setzt voraus, dass das Ausgangssignal zunächst außerhalb des Wertebereichs liegt. Das Hineinlaufen zeigt also an, dass überhaupt eine Reaktion auftritt, was gegebenenfalls bereits als Zeichen für ein funktionsfähiges IC gewertet werden kann.

Alternativ oder ergänzend kann ab diesem Zeitpunkt aber auch eine gewisse Wartezeit bis zur Beruhigung des Ausgangssignalverlaufs abgewartet werden. Die individuelle Testzeit setzt sich dann aus der Summe der Wartezeit und der vorhergehenden, schaltungsindividuellen Zeitspanne zwischen einem Stimulieren der integrierten Schaltung und dem Hineinlaufen des Ausgangssignals in den vorbestimmten Wertebereich zusammen.

Bei einer bevorzugten Ausgestaltung gilt die vorbestimmte Bedingung daher dann als erfüllt, wenn nach dem Hineinlaufen des Ausgangssignals in einen vorbestimmten Wertebereich eine vorbestimmte Mindestwartezeit abgelaufen ist.

Ferner ist bevorzugt, dass die vorbestimmte Bedingung dann als erfüllt gilt, wenn nach dem Hineinlaufen des Ausgangssignals in den vorbestimmten Wertebereich eine Steigung eines Verlaufs des Ausgangssignals über der Zeit einen vorbestimmten Schwellenwert unterschreitet.

Diese Ausgestaltung besitzt den zusätzlichen Vorteil, dass beide Zeitspannen, also die Zeitspanne zwischen einem Stimulieren der Schaltung und dem Hineinlaufen in den Wertebereich als auch die Zeitspanne zwischen dem Hineinlaufen und der Aufnahme des eigentlichen Messwerts, also dem Wert des Ausgangsignals zu dem Zeitpunkt, zu dem die vorbestimmte Bedingung erfüllt ist, schaltungsindividuell sind. Daraus ergibt sich eine weitere Verkürzung der Testzeit und damit eine weitere Erhöhung der Rate, mit der eine einzelne Testvorrichtung integrierte Schaltungen testet.

Bevorzugt ist auch, dass die vorbestimmte Bedingung dann als erfüllt gilt, wenn nach dem Hineinlaufen des Ausgangssignals in den vorbestimmten Wertebereich eine prozentuale Änderung des Ausgangssignals einen vorbestimmten Schwellenwert überschreitet.

Auch bei dieser Ausgestaltung sind beide vorstehend genannten Zeitspannen schaltungsindividuell, so dass sich hier vergleichbare Vorteile ergeben. Der Unterschied zwischen beiden Ausgestaltungen besteht darin, dass die Steigung von der Differenz zweier Ausgangssignalwerte abhängt, während sich die prozentuale Änderung als Funktion des Quotienten beider Ausgangssignalwerte ergibt.

Eine weitere bevorzugte Ausgestaltung zeichnet sich dadurch aus, dass die vorbestimmte Bedingung dann als erfüllt gilt, wenn eine durch eine Änderung des Eingangssignals ausgelöste prozentuale Änderung des Ausgangssignals einen vorbestimmten Schwellenwert überschreitet.

Diese auf den ersten Blick ähnliche Ausgestaltung unterscheidet sich von den vorstehend aufgelisteten Ausgestaltungen dadurch, dass sie nicht voraussetzt, dass das Ausgangsignal zu Beginn außerhalb des vorbestimmten Wertebereichs liegt. Bei Schaltungen, bei denen das Ausgangssignal von Anfang an im vorbestimmten Wertebereich liegt, kann so festgestellt werden, ob überhaupt eine ausreichende Änderung als Reaktion auf eine Stimulation eintritt. Diese Ausgestaltung eignet sich damit insbesondere für integrierte Schaltungen mit kleinen Ausgangssignalamplituden.

Mit Blick auf Ausgestaltungen der Testvorrichtung ist bevorzugt, dass die Testvorrichtung das Ausgangssignal nach einer Änderung des Eingangssignals fortlaufend überwacht und die vorbestimmte Bedingung dann als erfüllt wertet, wenn das Ausgangssignal in einen vorbestimmten Wertebereich hineinläuft.

Bevorzugt ist auch, dass die Testvorrichtung das Ausgangssignal nach einer Änderung des Eingangssignals fortlaufend überwacht und die vorbestimmte Bedingung dann als erfüllt wertet, wenn eine durch eine Änderung des Eingangssignals ausgelöste prozentuale Änderung des Ausgangssignals einen vorbestimmten Schwellenwert überschreitet.

Ferner ist bevorzugt, dass die Testvorrichtung wenigstens eine der oben genannten Ausgestaltungen des Verfahrens ausführt.

Diese Ausgestaltungen der Testvorrichtung besitzen die Vorteile des korrespondierenden Verfahrens und der zugehörigen Ausgestaltungen. Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: eine Testvorrichtung zum Testen integrierter Schaltungen;
- Fig. 2: Signalverläufe, die eine solche Testvorrichtung im Rahmen erster Ausgestaltungen über der Zeit ausgibt und/oder erfasst;
- Fig. 3: Signalverläufe, die eine solche Testvorrichtung im Rahmen zweiter Ausgestaltungen über der Zeit ausgibt und/oder erfasst;
- Fig. 4: ein Flussdiagramm als Ausführungsbeispiel eines erfindungsgemäßen Verfahrens in allgemeiner Form; und
- Fig. 5: ein weiteres Flussdiagramm mit Ausgestaltungen des Verfahrens nach der Fig. 4.

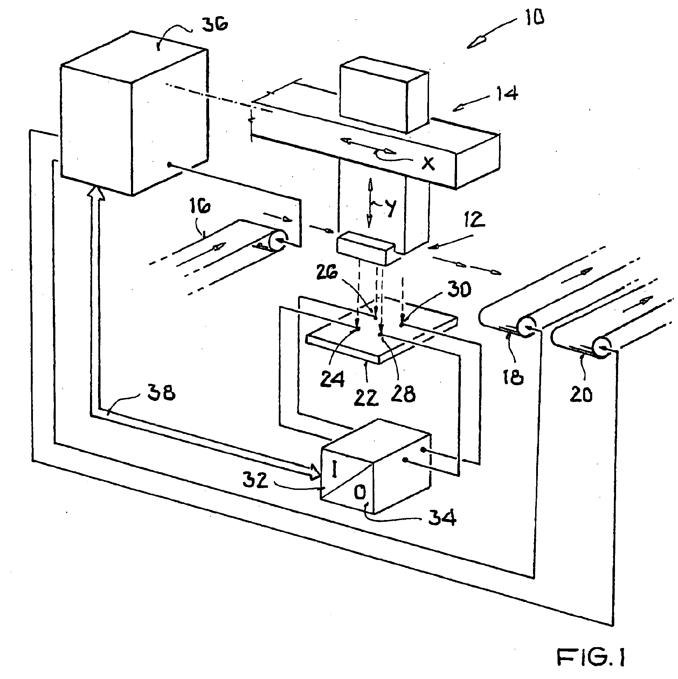

Figur 1 zeigt eine Testvorrichtung 10 zum Testen integrierter Schaltungen 12 mit einer Greifvorrichtung 14, Zufuhrtransportmitteln 16, einem Abfuhrtransportmittel 18 für integrierte Schaltungen, die vorgegebene Anforderungen erfüllen, einem Abfuhrtransportmittel 20 für integrierte Schaltungen, die vorgegebene Anforderungen nicht erfüllen, einer Trägervorrichtung 22, einem Eingangssignalgenerator 32, einer Ausgangssignal-Erfassungs- und Auswerteeinheit 34, einer Steuervorrichtung 36 und einer Steuerverbindung 38. Zu testende integrierte Schaltungen 12 werden von dem Zufuhrtransportmittel 16, beispielsweise einem Förderband, angeliefert und von der in X- und Y-Richtung beweglichen Greifvorrichtung 14 erfasst und zur Trägerplatte 22 transportiert. Die Trägerplatte 22 weist Eingangssignalkontakte 24, 26 und Ausgangssignalkontakte 28, 30 auf. Die Eingangssignalkontakte 24, 26 sind mit dem Eingangssignalgenerator 32 verbunden und die Ausgangssignalkontakte 28, 30 sind mit der Ausgangssignal-Erfassungs- und Auswerteeinheit 34 verbunden.

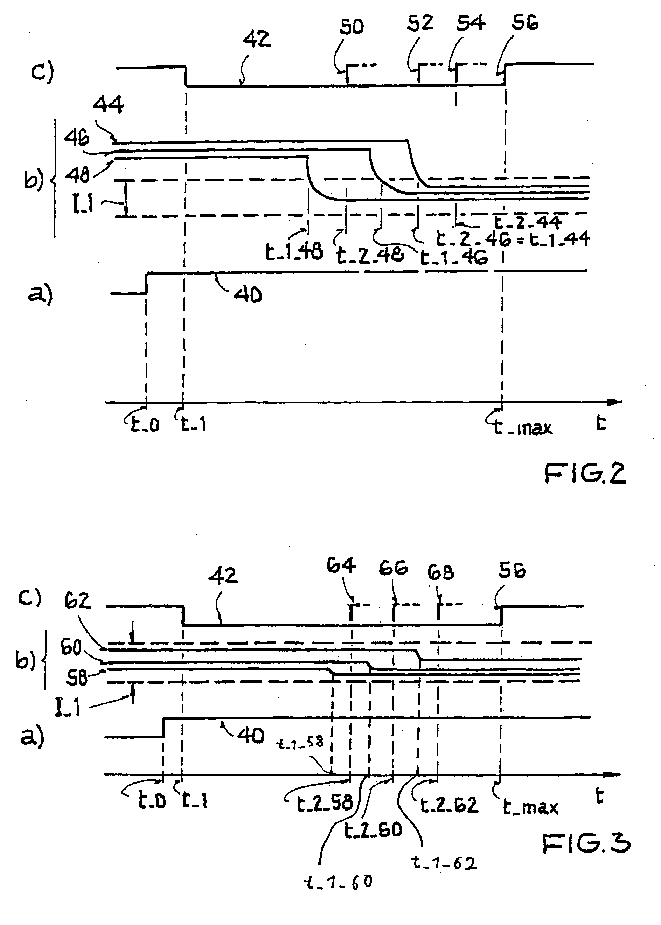

Der Eingangssignalgenerator 32 stimuliert die auf den Kontakten 24, 26, 28, 30 abgesetzte integrierte Schaltung 12, die darauf mit einer Änderung ihres Ausgangssignals reagiert. Die Ausgangssignaländerung wird von der Ausgangssignal-Erfassungs- und Auswerteeinheit 34 erfasst und ausgewertet. Je nachdem, ob die getestete integrierte Schaltung 12 vorbestimmte Anforderungen erfüllt oder nicht erfüllt, wird sie von der Greifvorrichtung 14 zu dem Abfuhrtransportmittel 18 oder dem Abfuhrtransportmittel 20 transportiert. Die Greifvorrichtung 14, das Zufuhrtransportmittel 16 und die Abfuhrtransportmittel 18 und 20 werden von einer Steuerung 36 gesteuert, die über eine Steuerverbindung 38, zum Beispiel ein Bussystem, mit dem Eingangssignalgenerator 32 und/oder der Ausgangssignal-Erfassungs- und Auswerteeinheit 34 kommuniziert. Die Testvorrichtung 10 nach Figur 1 zeichnet sich dadurch aus, dass sie die vorbestimmte Bedingung, bei deren Eintritt ein Messwert des Ausgangssignals der integrierten Schaltung zur Beurteilung der Funktion der integrierten Schaltung 12 erfasst wird, aus einem Zeitverhalten des Ausgangssignals ableitet. Ausgestaltungen entsprechender Verfahrensabläufe werden im Folgenden unter Bezug auf die Figuren 2 bis 5 erläutert.

Dazu zeigt die Figur 2 in ihrem Teil a) den zeitlichen Verlauf eines stimulierenden Eingangssignals, in ihrem Teil b) individuell verschiedene Reaktionen verschiedener integrierter Schaltungen 12 einer Baureihe über der Zeit t und in ihrem Teil c) individuelle Testzeiten für integrierte Schaltungen 12, die Ausgangssignale nach Figur 2 b) liefern. Der Test beginnt mit einer Änderung des vom Eingangssignalgenerator 32 gelieferten Eingangssignals 40 zum Zeitpunkt t_0. Nach Ablauf einer Mindestwartezeit wird zum Zeitpunkt t_1 der aktive Test, das heißt eine fortlaufende Überwachung des Ausgangssignals der zu testenden integrierten Schaltung 12 und damit des Zeitverhaltens des Ausgangssignals gestartet. Die fortlaufende Überwachung kann durch periodisches Abtasten oder eine kontinuierliche Auswertung realisiert sein. Der Zeitpunkt t_1 ist in der Figur 2 durch den fallenden Pegel des Signals 42 in der Figur 2 c) dargestellt, das den Beginn der aktiven Testzeit markiert.

Figur 2 b) zeigt Ausgangssignalverläufe 44, 46 und 48 von drei verschiedenen integrierten Schaltungen 12, die sich in ihrer Reaktionsgeschwindigkeit unterscheiden. Von den drei betrachteten Ausgangssignalverläufen 44, 46, 48 reagiert der Verlauf 48 am schnellsten auf eine Eingangssignaländerung zum Zeitpunkt t_0 und läuft zum Zeitpunkt t_1_48 in einen vorbestimmten Wertebereich I_1 hinein. In einer Ausgestaltung der Erfindung kann dieses Hineinlaufen in den Wertebereich I_1 bereits als Erfüllen der vorbestimmten Bedingung gewertet werden. Im Rahmen dieser Ausgestaltung kann der Test für diesen speziellen IC zu diesem Zeitpunkt beendet werden.

Im Rahmen einer weiteren Ausgestaltung wird jedoch noch eine gewisse Zeit bis zum Zeitpunkt t_2_48 abgewartet, und der dann vorliegende Wert des Ausgangssignals 48 als Messwert für eine Beurteilung der integrierten Schaltung 12 verwendet. Im Rahmen dieser Ausgestaltung gilt die vorbestimmte Bedingung also dann als erfüllt, wenn der Zeitpunkt t_2_48 = t_1_48 + Δ_t erreicht ist. In diesem Fall wird die Testmessung beendet, was in der Figur 2 c) durch die steigende Flanke 50 repräsentiert wird. Alternativ kann der Zeitpunkt t_2_48 auch durch Auswerten der Steigung des Signals 48 bestimmt werden. Die nach dem Zeitpunkt t_1_48 anfänglich große Steigung nimmt mit zunehmender Annäherung an den Zeitpunkt t_2_48 ab, so dass ein Unterschreiten eines entsprechenden Schwellenwertes den Zeitpunkt t_2_48 definieren kann.

Ganz analog zu diesen Betrachtungen zum Ausgangssignalverlauf 48 können auch die Ausgangssignalverläufe 46 und 44 ausgewertet werden, die bei Messungen an anderen integrierten Schaltungen 12 erhalten werden. Das durch den Verlauf 46 repräsentierte Ausgangssignal 46 läuft zum Zeitpunkt t_1_46 in den Wertebereich I_1 und wird beispielsweise zum Zeitpunkt t_2_46 zur Beurteilung der Funktionsfähigkeit der integrierten Schaltung 12 erfasst. Entsprechend kann die Testmessung für diese integrierte Schaltung 12 zum Zeitpunkt t_2_46 abgebrochen werden, was in der Figur 2 c) durch die steigende Flanke 52 repräsentiert wird.

Entsprechend ergibt sich aus den Zeitpunkten t_1_44, zu denen das Ausgangssignal 44 in den Wertebereich I_1 hineinläuft, und dem zugehörigen Zeitpunkt t_2_44, zu dem ein Messwert aufgenommen wird, ein Testende, das durch die steigende Flanke 54 in Figur 2 c) repräsentiert wird.

Die steigende Flanke 56 in der Figur 2 repräsentiert einen zwangsläufig erfolgenden Abbruch des Testes zu einem Zeitpunkt t_max. Wenn die vorbestimmte Bedingung für das Erfassen eines Ausgangssignals 44, 46, 48 einer speziellen integrierten Schaltung 12 zu diesem Zeitpunkt t_max noch nicht erfüllt ist, kann beispielsweise der dann aktuelle Wert des Ausgangssignals 44, 46 48 als Messwert für eine Beurteilung der Funktionsfähigkeit verwendet werden und mit vorgegebenen Grenzwerten verglichen werden. Das Vorsehen der maximalen Testzeit t_max verhindert, dass ein möglicherweise nicht funktionsfähiger IC die Testvorrichtung 10 unzulässig lange blockiert.

Der Zeitpunkt t_max definiert gleichzeitig ein Beispiel für den Zeitpunkt, zu dem bei dem eingangs angegebenen bekannten Verfahren die Messwerte für jeden einzelnen IC 12 aufgenommen worden sind. Die gesamte Messzeit einer Vielzahl von integrierten Schaltungen 12 wird nach dem bekannten Verfahren also durch ein entsprechendes Vielfaches der Zeitspanne zwischen den Zeitpunkten t_1 und t_max nach unten begrenzt. Im Gegensatz dazu ergibt sich eine vergleichbare (theoretische) untere Grenze für ein Testverfahren nach der Erfindung als Summe der Abstände von jeder der Flanken 50, 52 und 54 zum Zeitpunkt t_1, was ersichtlich zu einer kleineren Summe und damit insgesamt zu einer Verkürzung der Testzeit für eine Vielzahl von integrierten Schaltungen 12 führt.

Alternativ zu den bereits beschriebenen Ausgestaltungen kann die Beurteilung einer integrierten Schaltung 12 auch dadurch erfolgen, dass nach dem Hineinlaufen des Ausgangssignals 44, 46, 48 in den vorbestimmten Wertebereich I_1 eine prozentuale Änderung des Ausgangssignals 44, 46, 48 bestimmt und mit einem vorbestimmten Schwellenwert verglichen wird. Die prozentuale Änderung kann zum Beispiel auf den Wert des Ausgangssignals 44, 46, 48 zum Zeitpunkt des Eintretens in den vorbestimmten Wertebereich I_1 normiert werden.

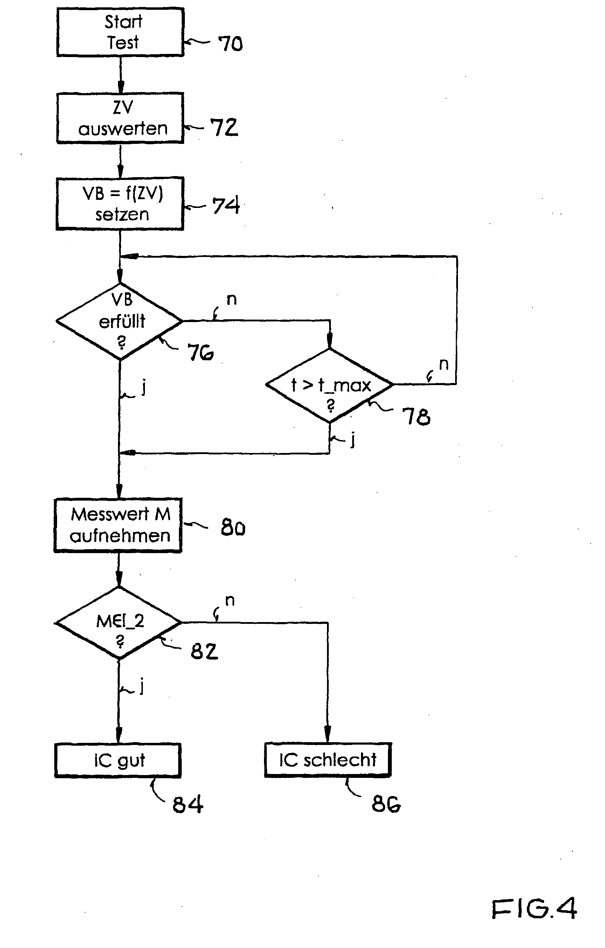

Figur 3 zeigt Signalverläufe 58, 60, 62 individueller integrierter Schaltungen 12, die gleich zu Beginn des Testes in dem erlaubten, vorbestimmten Wertebereich I_1 liegen. In diesem Fall lässt sich eine zuverlässige Beurteilung dadurch erzielen, dass die Ausgangssignalverläufe 58, 60, 62 nach dem Zeitpunkt t_1 fortlaufend erfasst und auf das Auftreten einer prozentualen Änderung überwacht werden, die einen vorbestimmten Schwellenwert überschreitet. Die prozentuale Änderung wird vorteilhafterweise auf das anfängliche Niveau der Ausgangssignalverläufe 58, 60, 62 bezogen. Sobald die Änderung des Ausgangssignals 58, 60, 62 einen prozentualen Schwellenwert überschreitet, was in der Figur 3 zu den Zeitpunkten t_1_58, t_1_60, t_1_62 der Fall ist, kann die betreffende Schaltung 12 als funktionsfähig beurteilt werden.

Alternativ kann zu diesen Zeitpunkten jeweils der Wert des Ausgangssignals 58, 60, 62 der betreffenden Schaltung 12 erfasst werden und mit vorgegebenen Grenzwerten, die von den Grenzen des vorbestimmten Wertebereichs I_1 identisch sein können oder abweichen können, verglichen werden.

Im Rahmen einer weiteren Ausgestaltung, die im Folgenden mit Bezug auf das Ausgangssignal 58 erläutert wird, erfolgt noch ein Abwarten bis zum Zeitpunkt t_2_58. Der dann vorliegende Wert des Ausgangssignals 58 wird als Messwert für eine Beurteilung der integrierten Schaltung 12 verwendet. Im Rahmen dieser Ausgestaltung gilt die Bedingung also dann als erfüllt, wenn der Zeitpunkt t_2_58=t_1_58+Δ_t erreicht ist. In diesem Fall wird die Testmessung beendet, was in der Figur 3c) durch die steigende Flanke 64 repräsentiert wird. Alternativ kann der Zeitpunkt t_2_58 auch durch Auswerten der Steigung des Signals 58 bestimmt werden. Die nach dem Zeitpunkt t_1_58 große Steigung nimmt mit zunehmender Annäherung an den Zeitpunkt t_2_58 ab, so dass ein Unterschreiten eines entsprechenden Schwellenwertes den Zeitpunkt t_2_58 definieren kann. Analog zu diesen Betrachtungen zum Ausgangssignalverlauf 58 können auch die Ausgangsverläufe 60 und 62 ausgewertet werden.

Entsprechend endet der Test einer integrierten Schaltung 12 bei dem Verfahren nach der Figur 3 jeweils bei steigenden Flanken 64, 66 und 68, die allesamt zeitlich vor der steigenden Flanke 56 liegen, die einen zwangsläufigen Abbruch des Testes zum Zeitpunkt t_max repräsentiert.

Figur 4 zeigt ein Ausführungsbeispiel eines erfindungsgemäßen Verfahrens in einer allgemeinen Form, mit dem sich die Signalverläufe, die in den Figuren 2 und 3 dargestellt sind, erzielen und auswerten lassen. Das Verfahren wird in der Testvorrichtung 10 nach Figur 1 durch den Verbund aus der Steuerung 36 mit dem Eingangssignalgenerator 32 und der Ausgangssignal-Erfassungs- und Auswerteeinheit 34 durchgeführt. Dazu wird in einem Schritt 70 zunächst ein Test gestartet, wenn die Greifvorrichtung 14 einen IC 12 auf der Trägerplatte 22 abgesetzt hat. Nach dem Absetzen eines ICs 12 auf den Kontakten 24, 26, 28, 30 wird eine Eingangssignaländerung ausgelöst und im Schritt 72 das Zeitverhalten ZV des resultierenden Ausgangssignals AS; 44, 46, 48; 58, 60, 62 ausgewertet. Anschließend wird im Schritt 74 eine vorbestimmte Bedingung VB als Funktion des Zeitverhaltens ZV gesetzt.

Bei fortlaufender weiterer Erfassung des Ausgangssignals AS; 44, 46, 48; 58, 60, 62 wird im Schritt 76 überprüft, ob die vorbestimmte Bedingung erfüllt ist. Solange dies nicht der Fall ist, erfolgt ein Verzweigen in den Schritt 78, in dem überprüft wird, ob die maximale Testzeit t_max überschritten ist. Bei Verneinung dieser Abfrage im Schritt 78 wird die Schleife aus den Schritten 76 und 78 so lange durchlaufen, bis entweder die vorbestimmte Bedingung im Schritt 76 erfüllt wird oder die maximale Testzeit im Schritt 78 überschritten wird. In beiden Fällen schließt sich ein Verzweigen zum Schritt 80 an, in dem ein Messwert M des Ausgangssignals AS; 44, 46, 48; 58, 60, 62 der integrierten Schaltung 12 aufgenommen wird.

Der aufgenommene Messwert M wird im Schritt 82 daraufhin überprüft ob er Element eines erlaubten Wertebereiches I_2 ist. Es versteht sich, dass I_2 mit dem in Zusammenhang mit den Figuren 2 und 3 erläuterten Wertebereich I_1 identisch sein kann oder aber auch davon abweichen kann. Wenn der Messwert M im Intervall I_2 liegt, gilt der getestete IC 12 als funktionsfähig und es wird zum Schritt 84 verzweigt, der einen Abtransport des ausreichend funktionsfähigen integrierten Schaltkreises 12 über das Abfuhrtransportmittel 18 auslöst. Andernfalls, also wenn der Messwert M nicht innerhalb des Intervalls I_2 liegt, wird zum Schritt 86 verzweigt, in dem beispielsweise ein Abtransport des getesteten IC 12 über das Abfuhrtransportmittel 20 erfolgt.

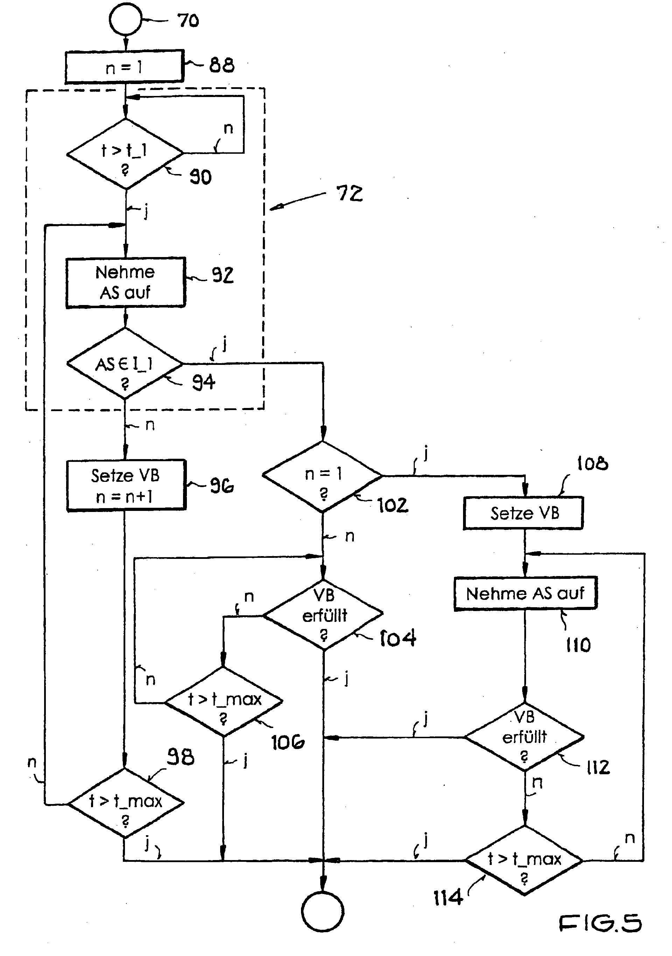

Nach dieser Darstellung eines sehr allgemeinen Verfahrens wird im Folgenden unter Bezug auf die Figur 5 eine detailliertere Ausgestaltung eines Verfahrens beschrieben, mit dem sich die Signalverläufe nach der Figur 2 als auch die Signalverläufe nach der Figur 3 erzielen und auswerten lassen. Nach dem Start des Programms im Schritt 70 wird zunächst eine Zählvariable n auf den Wert 1 gesetzt. Daran schließt sich der Schritt 72 des Auswertens des Zeitverhaltens ZV des Ausgangssignals AS; 44, 46, 48; 58, 60, 62 einer integrierten Schaltung 12 an. Die Auswertung des Zeitverhaltens ZV ist in der Figur 5 detaillierter dargestellt und beginnt mit einem Teilschritt 90 des Schritts 72, in dem überprüft wird, ob die im Zusammenhang mit den Figuren 2 und 3 erläuterte Mindestwartezeit bis zum Zeitpunkt t_1 verstrichen ist. Erst wenn dies der Fall ist, erfolgt ein Verzweigen zum Teilschritt 92, in dem ein Ausgangssignal AS; 44, 46, 48; 58, 60, 62 der integrierten Schaltung 12 aufgenommen wird. Daran schließt sich ein Teilschritt 94 an, in dem das Ausgangssignal AS; 44, 46, 48; 58, 60, 62 daraufhin überprüft wird, ob es in dem vorbestimmten Wertebereich I_1 liegt. Wenn dies nicht der Fall ist, was dem in der Figur 2 dargestellten Ausgangssignalverhalten entspricht, schließt sich ein Schritt 96 an, in dem eine der in Zusammenhang mit der Figur 2 erläuterten vorbestimmten Bedingungen VB gesetzt wird. Außerdem wird in Schritt 96 der Wert der Zählvariable n um 1 erhöht.

Dann wird im Schritt 98 überprüft, ob die maximale Testzeit t_max abgelaufen ist. Solange dies nicht der Fall ist, wird zum Teilschritt 92 zurückverzweigt, in dem ein neues Ausgangssignal AS; 44, 46, 48 aufgenommen wird. Daran schließt sich wieder der Schritt 94 an, also eine Feststellung, ob der Wert AS im Intervall I_1 liegt. Solange dies nicht der Fall ist und die maximale Testzeit t_max nicht überschritten wird, wird die Schleife aus den Schritten 92, 94, 96, 98 durchlaufen, wobei der Wert der Zählvariable n jeweils erhöht und damit immer von n = 1 abweicht. Erst wenn im Schritt 94 festgestellt wird, dass das Ausgangssignal AS; 44, 46, 48 in den erlaubten Wertebereich I_1 hineinläuft, wird die Schleife verlassen und, da die Zählvariable n in diesem Fall größer als 1 ist, durch Verneinung der entsprechenden Abfrage im Schritt 102 der Schritt 104 erreicht, in dem geprüft wird, ob die vorbestimmte Bedingung VB erfüllt ist.

Solange dies nicht der Fall ist, erfolgt ein Verzweigen aus dem Schritt 104 in den Schritt 106, in dem überprüft wird, ob die maximale Testzeit t_max erreicht ist. Erst wenn die vorbestimmte Bedingung im Schritt 104 als erfüllt erkannt wird oder wenn die vorbestimmte maximale Testzeit t_max im Schritt 106 als überschritten erkannt wird, erfolgt ein Verzweigen in den Schritt 80, der bereits im Zusammenhang mit der Figur 4 erläutert worden ist und der die Messwertaufnahme und Weiterverzweigung in die Schritte 82, 84, 86 der Figur 4 betrifft. Der Schritt 80 wird auch erreicht, wenn die Schleife aus den Schritten 92, 94, 96 und 98 durch ein Überschreiten der maximalen Testzeit t_max aus dem Schritt 98 heraus verlassen wird.

Wenn das Ausgangssignal zum Zeitpunkt t_1 im erlaubten Bereich I_1 liegt, wie es den Verhältnissen der Figur 3 entspricht, ergibt sich ein etwas anderer Ablauf des Verfahrens. In diesem Fall wird die Abfrage im Teilschritt 94 des Schrittes 72 gleich beim ersten Durchlaufen bejaht und der Schritt 102 erreicht, in dem überprüft wird, ob die Zählvariable n den Wert 1 besitzt. Da dies bei einem nur einmaligen Durchlaufen des vorhergehenden Schrittes 94 der Fall ist, wird die Abfrage 102 in diesem Fall bejaht und es schließt sich der Schritt 108 an, in dem eine der in Zusammenhang mit der Figur 3 erläuterten vorbestimmten Bedingungen VB gesetzt wird. Anschließend wird im Schritt 110 ein Ausgangssignal AS; 58, 60, 62 aufgenommen und im Schritt 112 daraufhin ausgewertet, ob die gesetzte vorbestimmte Bedingung VB erfüllt ist. Sobald die vorbestimmte Bedingung VB erfüllt ist, schließt sich auch bei dieser Ausgestaltung des Verfahrens ein Verzweigen in den Schritt 80 zur Aufnahme eines Messwertes für das Ausgangssignal AS; 58, 60, 62 als Basis für eine Beurteilung der Funktionsfähigkeit der integrierten Schaltung 12 an.

Solange die vorbestimmte Bedingung jedoch nicht erfüllt ist und die im Schritt 114 überprüfte Maximalzeit t_max noch nicht erreicht ist, wird die Folge aus den Schritten 110, 112 und 114 wiederholt durchlaufen. Ähnlich wie bei der vorher beschriebenen Ausgestaltung wird auch diese Schleife entweder dadurch verlassen, dass die vorbestimmte Bedingung im Schritt 112 als erfüllt erkannt wird oder dadurch, dass die maximale Testzeit t_max im Schritt 114 als überschritten erkannt wird.

## Patentansprüche

1. Verfahren zum Testen integrierter Schaltungen (12), die ein Analog-Ausgangssignal (AS; 44, 46, 48; 58, 60, 62) liefern, mit den Schritten: Erzeugen einer Änderung eines Eingangssignals (40) der integrierten Schaltung (12), Erfassen einer Änderung des Ausgangssignals (AS; 44, 46, 48; 58, 60, 62) der integrierten Schaltung (12), die durch die Änderung des Eingangssignals (40) ausgelöst wurde, wenn eine vorbestimmte Bedingung (VB) erfüllt ist und Vergleichen des erfassten Ausgangssignals (M; AS; 44, 46, 48; 58, 60, 62) mit wenigstens einem vorbestimmten Vergleichskriterium, **dadurch gekennzeichnet, dass** die vorbestimmte Bedingung (VB) individuell für jede integrierte Schaltung (12) aus einem Zeitverhalten (ZV) des Ausgangssignals (AS; 44, 46, 48; 58, 60, 62) abgeleitet wird.

2. Verfahren nach Anspruch 1, **dadurch gekennzeichnet, dass** das Ausgangssignal (AS; 44, 46, 48; 58, 60, 62) nach einer Änderung des Eingangssignals (40) fortlaufend überwacht wird und dass die vorbestimmte Bedingung (VB) dann als erfüllt gilt, wenn das Ausgangssignal (AS; 44, 46, 48; 58, 60, 62) in einen vorbestimmten Wertebereich (I_1) hineinläuft.

3. Verfahren nach Anspruch 2, **dadurch gekennzeichnet, dass** die vorbestimmte Bedingung (VB) dann als erfüllt gilt, wenn nach dem Hineinlaufen des Ausgangssignals (AS; 44, 46, 48; 58, 60, 62) in den vorbestimmten Wertebereich (I_1) eine vorbestimmte Mindestwartezeit abgelaufen ist.

4. Verfahren nach Anspruch 2, **dadurch gekennzeichnet, dass** die vorbestimmte Bedingung (VB) dann als erfüllt gilt, wenn nach dem Hineinlaufen des Ausgangssignals (AS; 44, 46, 48; 58, 60, 62) in den vorbestimmten Wertebereich (I_1) eine Steigung eines Verlaufs des Ausgangssignals (AS; 44, 46, 48; 58, 60, 62) über der Zeit (t) einen vorbestimmten Schwellenwert unterschreitet.

5. Verfahren nach Anspruch 2, **dadurch gekennzeichnet, dass** die vorbestimmte Bedingung (VB) dann als erfüllt gilt, wenn nach dem Hineinlaufen des Ausgangssignals (AS; 44, 46, 48; 58, 60, 62) in den vorbestimmten Wertebereich (I_1) eine prozentuale Änderung des Ausgangssignals (AS; 44, 46, 48; 58, 60, 62) einen vorbestimmten Schwellenwert überschreitet.

6. Verfahren nach Anspruch 1, **dadurch gekennzeichnet, dass** die vorbestimmte Bedingung (VB) dann als erfüllt gilt, wenn eine durch eine Änderung des Eingangssignals (40) ausgelöste prozentuale Änderung des Ausgangssignals (AS; 44, 46, 48; 58, 60, 62) einen vorbestimmten Schwellenwert überschreitet.

7. Testvorrichtung (10) für integrierte Schaltungen (12) mit Handhabungsmitteln (14, 16, 18, 20, 22) zum Kontaktieren von integrierten Schaltungen (12), einem Eingangssignalgenerator (32) und einer Ausgangssignal-Erfassungs- und Auswerteeinheit (34), wobei die Testvorrichtung (10) eine Änderung eines Eingangssignals (40) einer integrierten Schaltung (12) erzeugt, und eine Änderung eines Ausgangssignals (AS; 44, 46, 48; 58, 60, 62) der integrierten Schaltung (12) erfasst, die durch die Änderung des Eingangssignals (40) ausgelöst wurde, wenn eine vorbestimmte Bedingung (VB) erfüllt ist und das erfasste Ausgangssignal (AS; 44, 46, 48; 58, 60, 62) mit wenigstens einem vorbestimmten Vergleichskriterium vergleicht, **dadurch gekennzeichnet, dass** die Testvorrichtung (10) die vorbestimmte Bedingung individuell für jede integrierte Schaltung (12) aus einem Zeitverhalten (ZV) des Ausgangssignals (AS; 44, 46, 48; 58, 60, 62) ableitet.

8. Testvorrichtung (10) nach Anspruch 7, **dadurch gekennzeichnet, dass** die Testvorrichtung (10) das Ausgangssignal (AS; 44, 46, 48; 58, 60, 62) nach einer Änderung des Eingangssignals (40) fortlaufend überwacht und die vorbestimmte Bedingung (VB) dann als erfüllt wertet, wenn das Ausgangssignal (AS; 44, 46, 48; 58, 60, 62) in einem vorbestimmten Wertebereich (I_1) hineinläuft.

9. Testvorrichtung (10) nach Anspruch 7, **dadurch gekennzeichnet, dass** die Testvorrichtung (10) das Ausgangssignal (AS; 44, 46, 48; 58, 60, 62) nach einer Änderung des Eingangssignals (40) fortlaufend überwacht und die vorbestimmte Bedingung (VB) dann als erfüllt wertet, wenn eine durch eine Änderung des Eingangssignals (40) ausgelöste prozentuale Änderung des Ausgangssignals (AS; 44, 46, 48; 58, 60, 62) einen vorbestimmten Schwellenwert überschreitet.

10. Testvorrichtung (10) nach wenigstens einem der Ansprüche 8 oder 9, **dadurch gekennzeichnet, dass** die Testvorrichtung (10) wenigstens eines der Verfahren nach den Ansprüchen 3 bis 5 ausführt.
